# EUROPÄISCHE PATENTSCHRIFT

(11) **EP 3 469 113 B1**
(45) Veröffentlichungstag und Bekanntmachung des Hinweises auf die Patenterteilung: **03.11.2021**
(21) Anmeldenummer: 17732345.8
(22) Anmeldetag: 08.06.2017
(51) Int. Cl.: C23C 14/56, C23C 16/54, B65H 41/00

(54) **VERFAHREN ZUM BESCHICHTEN EINES MIT EINER SCHUTZFOLIE VERSEHENEN FLEXIBLEN SUBSTRATES**
METHOD FOR COATING A FLEXIBLE SUBSTRATE PROVIDED WITH A PROTECTIVE FILM
PROCÉDÉ DE REVÊTEMENT D'UN SUBSTRAT FLEXIBLE MUNI D'UN FILM DE PROTECTION

(30) Priorität: 10.06.2016 DE 102016110737
(43) Veröffentlichungstag der Anmeldung: 17.04.2019
(73) Patentinhaber: Fraunhofer-Gesellschaft zur Förderung der angewandten Forschung e.V., 80686 München (DE)
(72) Erfinder: FAHLAND, Matthias, 01257 Dresden (DE); MEYER, Uwe, 01477 Arnsdorf (DE); VOGT, Tobias, 01129 Dresden (DE); GÜNTHER, Steffen, 01217 Dresden (DE); FAHLTEICH, John, 01279 Dresden (DE); PRAGER, Nicole, 01723 Grumbach (DE)
(86) Internationale Anmeldenummer: PCT/EP2017/064030
(87) Internationale Veröffentlichungsnummer: WO 2017/211989

(56) Entgegenhaltungen:
- EP-A1- 2 228 463
- EP-A1- 2 883 822
- WO-A1-2015/010036
- WO-A1-2015/198701
- JP-A- 2012 177 179
- JP-A- 2014 074 221

## Beschreibung

Die Erfindung betrifft ein Verfahren zum Beschichten eines flexiblen Substrates, wobei das flexible Substrat eine Schutzfolie aufweist, die vor dem Beschichten entfernt wird.

Es sind verschiedene Verfahren und Vorrichtungen zum Beschichten von flexiblen Substraten bekannt, bei denen die flexiblen Substrate während des Beschichtens eine Prozesswalze teilweise umschlingen. Als Prozesswalze sollen nachfolgend derartige Walzen verstanden werden, über welche flexible Substrate während eines Beschichtungsprozesses geführt werden, um die Substrattemperatur auf eine für das Beschichten vorteilhafte Temperatur einzustellen. Bei vielen Anwendungsfällen sind derartige Prozesswalzen als Kühlwalzen ausgebildet. So sind beispielsweise aus DE 10 2008 028 542 A1 Verfahren bekannt, bei denen ein flexibles Substrat über eine Kühlwalze geführt wird, während eine Schicht mittels eines Sputtermagnetrons auf dem flexiblen Substrat abgeschieden wird.

Bei einigen Anwendungsfällen bestehen hohe Anforderungen hinsichtlich des Reinheitsgrades der Oberfläche eines zu beschichtenden flexiblen Substrates, um die Funktionalität einer darauf abgeschiedenen Schicht zu gewährleisten. Es ist daher auch bekannt, die zu beschichtende Oberfläche eines flexiblen Substrates mit einer Schutzfolie zu versehen, welche die zu beschichtende Oberfläche vor Verschmutzungen und Beschädigungen schützt, wobei die Schutzfolie erst in einer Beschichtungseinrichtung vom flexiblen Substrat abgezogen wird.

Aus EP 2 228 463 A ist ein Verfahren bekannt, bei dem ein flexibles Substrat nach einem ersten Beschichtungsvorgang in einer ersten Beschichtungsvorrichtung auf der beschichteten Seite mit einer Schutzfolie versehen und danach aufgewickelt wird. In der Wickelkammer einer zweiten Beschichtungsvorrichtung wird die Schutzfolie wieder abgezogen und das flexible Substrat über mehrere Umlenkrollen geführt, bis es eine Kühlwalze teilweise umschlingt. Dort wird das flexible Substrat einem zweiten Beschichtungsvorgang unterzogen und nach dem führen über mehrere Umlenkrollen schließlich wieder aufgewickelt. Nachteilig wirkt sich hierbei aus, dass die zu beschichtende Seite des flexiblen Substrates vor dem zweiten Beschichtungsvorgang an der Kühlwalze mit verschiedenen Umlenkrollen gelangen kann, was zu Verunreinigungen und/oder Beschädigungen der zu beschichtenden Oberfläche des Substrates bzw. der darauf abgeschiedenen Schicht führen kann.

Aus EP 2 883 822 A1 und JP 2012-177179 A sind Vorrichtungen bekannt, bei denen eine erste Schutzfolie von einem bandförmigen Substrat entfernt wird, bevor das Substrat an einer Beschichtungseinrichtung vorbeigeführt wird und wobei nach dem Beschichten des Substrates eine zweite Schutzfolie auf das Substrat aufgetragen wird. Nachteilig wirkt sich hierbei aus, dass beim Abziehen der ersten Schutzfolie elektrische Entladungen zwischen abgelöster Schutzfolie und Substrat entstehen können, welche Beschädigungen am Substrat herbeiführen können.

Ein weiteres Verfahren zum Beschichten eines flexiblen Substrats, wobei das flexible Substrat eine Schutzfolie aufweist, die vor dem Beschichten entfernt wird, wird in WO 2015/010036 A1 offenbart.

Der Erfindung liegt daher das technische Problem zugrunde, ein Verfahren zum Beschichten eines mit einer Schutzfolie versehene flexiblen Substrates zu schaffen, mittels dessen die Nachteile aus dem Stand der Technik überwunden werden können. Insbesondere soll es mit dem erfindungsgemäßen Verfahren auch möglich sein eine Schutzfolie mit einem gleichbleibenden Winkel vom flexiblen Substrat zu entfernen und dadurch Schichten mit sehr guten und homogenen Schichteigenschaften abzuscheiden.

Die Lösung des technischen Problems ergibt sich durch Gegenstände mit den Merkmalen des Patentanspruchs 1. Weitere vorteilhafte Ausgestaltungen der Erfindung ergeben sich aus den abhängigen Ansprüchen.

Beim erfindungsgemäßen Verfahren wird ein flexibles Substrat zum Beschichten über eine Prozesswalze geführt, wobei das flexible Substrat eine erste Schutzfolie aufweist, die vom flexiblen Substrat entfernt wird, bevor das flexible Substrat in die Beschichtungszone einer der Prozesswalze gegenüberliegenden Beschichtungseinrichtung gelangt. Die Beschichtungseinrichtung kann beispielsweise als Sputtermagnetron oder als Verdampfungseinrichtung ausgebildet werden. Erfindungsgemäß wird die erste Schutzfolie vom flexiblen Substrat jedoch erst entfernt, nachdem das flexible Substrat einen mechanischen Kontakt mit der Prozesswalzenoberfläche ausgebildet hat.

Des Weiteren wird eine zweite Schutzfolie auf die beschichtete Seite des flexiblen Substrates aufgetragen, nachdem das flexible Substrat die Beschichtungszone der Beschichtungseinrichtung verlassen hat und bevor der mechanische Kontakt zwischen Prozesswalzenoberfläche und flexiblem Substrat beendet wird.

Die vorliegende Erfindung wird nachfolgend anhand von Ausführungsbeispielen näher erläutert. Die Fig. zeigen:

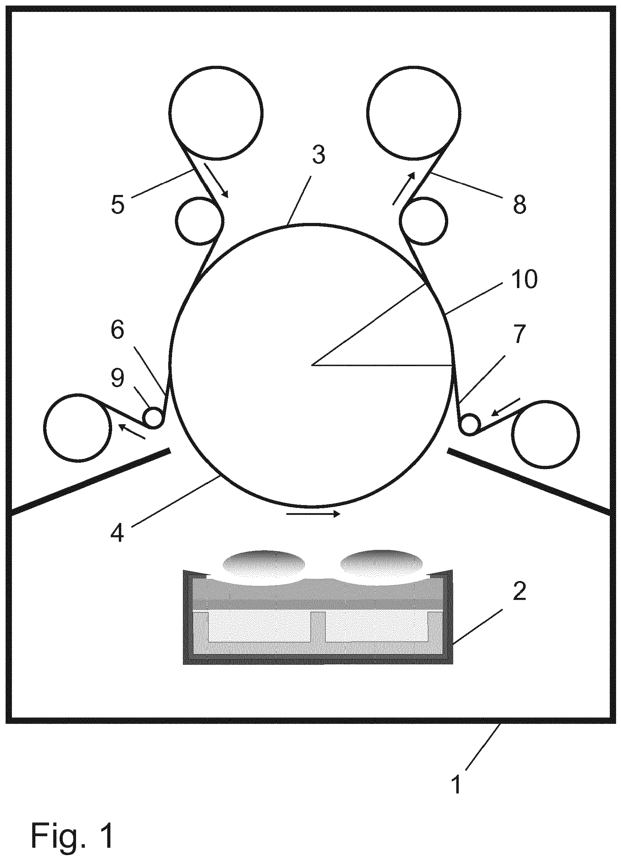

- Fig. 1: eine schematische Darstellung einer Vorrichtung zum Ausführen des erfindungsgemäßen Verfahrens.

In Fig. 1 ist eine Vorrichtung schematisch dargestellt, mittels der das erfindungsgemäße Verfahren durchgeführt werden kann. Die Vorrichtung umfasst eine Arbeitskammer 1, innerhalb der eine als Sputtermagnetron ausgebildete Beschichtungseinrichtung 2 und eine der Beschichtungseinrichtung 2 gegenüberliegende Prozesswalze 3 angeordnet sind, wobei sich die Prozesswalze 3 entgegengesetzt zum Uhrzeigersinn dreht. Mittels der Beschichtungseinrichtung 2 soll eine Schicht auf einer Seite eines flexiblen Substrates 4 abgeschieden werden. Beim erfindungsgemäßen Verfahren können auf der zu beschichtenden Seite des flexiblen Substrates 4 auch schon eine oder mehrere Schichten abgeschieden sein.

Zunächst wird ein Verbund 5, bestehend aus dem flexiblen Substrat 4 und einer ersten Schutzfolie 6 von einer Rolle abgewickelt und über eine oder mehrere Umlenkrollen derart geführt, dass das flexible Substrat 4 die Prozesswalze 3 teilweise umschlingt. Erfindungsgemäß wird die erste Schutzfolie 6 erst dann vom flexiblen Substrat 4 entfernt, nachdem das flexible Substrat 4 einen mechanischen Kontakt mit der Prozesswalze 3 ausgebildet hat.

Nachdem die erste Schutzfolie 6 vom flexiblen Substrat 4 abgezogen wurde, wird das flexible Substrat 4, anliegend an der Prozesswalze 3, durch die Beschichtungszone der Beschichtungseinrichtung 2 geführt und dabei ein Schicht auf dem flexiblen Substrat 4 abgeschieden.

Nachdem das flexible Substrat 4 die Beschichtungszone der Beschichtungseinrichtung 2 durchquert hat und noch vor dem Beenden des mechanischen Kontaktes zwischen dem flexiblen Substrat 4 und der Prozesswalze 3, wird eine zweite Schutzfolie 7 auf die beschichtete Seite des flexiblen Substrates 4 aufgetragen und anschließend der entstehende Verbund 8, bestehend aus flexiblem Substrat 4 und zweiter Schutzfolie 7 auf einer Rolle aufgewickelt. Damit eine gute Haftung zwischen dem beschichteten flexiblen Substrat 4 und der zweiten Schutzfolie 7 ausgebildet werden kann, ist es vorteilhaft, wenn die zweite Schutzfolie 7 derart auf das flexible Substrat 4 aufgetragen wird, dass mit dem Verbund 8 aus beschichtetem flexiblen Substrat 4 und zweiter Schutzfolie 7 noch in einem Winkelsegment 10 des Querschnitts der Prozesswalze 3 von mindestens 10° ein mechanischer Kontakt mit der Prozesswalzenoberfläche ausgebildet wird.

Das Abziehen der ersten Schutzfolie 6 vom flexiblen Substrat 4 auf der Prozesswalze 3 vor dem Beschichtungsprozess und das Aufbringen der zweiten Schutzfolie 8 auf die beschichtete Seite des flexiblen Substrates 4 nach dem Beschichtungsprozess sind jeweils kritische Schritte für die Qualität der abgeschiedenen Schicht. Wird eine Schutzfolie von einem bandförmigen flexiblen Substrat über die Länge des bandförmigen flexiblen Substrates betrachtet mit einem sich verändernden Winkel zwischen flexiblem Substrat und der Schutzfolie abgezogen, kann dies zu einer inhomogenen Oberflächenbeschaffenheit des flexiblen Substrates führen, was sich nachteilig auf die Qualität der nachfolgend abgeschiedenen Schicht auswirken kann. Es ist daher vorteilhaft, das Abziehen der ersten Schutzfolie 6 vom flexiblen Substrat 4 unter einem konstanten Winkel durchzuführen, um mögliche Toleranzen der Beschichtungsqualität klein zu halten. Erschwert wird dies durch den Sachverhalt, dass die Haftung zwischen flexiblem Substrat 4 und erster Schutzfolie 6 über die Länge des flexiblen Substrates 4 unterschiedlich ausgebildet sein kann. Aus diesem Grund wird beim erfindungsgemäßen Verfahren die erste Schutzfolie 6 vom flexiblen Substrat 4 erst dann abgezogen, wenn das flexible Substrat einen mechanischen Kontakt mit der Prozesswalze ausbildet. Auf diese Weise ist sichergestellt, dass das mit einem Anpressdruck über die Prozesswalze geführte flexible Substrat 4 zum Zeitpunkt des Ablösens der ersten Schutzfolie, über die Länge des flexiblen Substrates 4 betrachtet, eine immer konstante Lage im Raum aufweist. Zum Fixieren der ersten Schutzfolie 6 beim Vorgang des Entfernens vom flexiblen Substrat4 wird die erste Schutzfolie über eine fest installierte Führungswalze 9 geführt, die dafür sorgt, dass die Kraft, die zum Abziehen der ersten Schutzfolie 6 vom flexiblen Substrat 4 ausgeübt wird, immer konstant ist.

Erfindungsgemäß wird die Führungswalze 9 mit einem Maß von 0,5 mm bis 5 mm von der Prozesswalze 9 beabstandet und übt somit keinen Druck auf das Substrat 4 aus, was anderenfalls zum Beschädigen der Substratoberfläche führen könnte. Außerdem wird diese Führungswalze 9 bezüglich des Walzendurchmessers derart dimensioniert, dass das Freischwingmaß der vom Substrat 4 abgezogenen Schutzfolie 6 eine Länge von 5 mm bis 50 mm aufweist. Das Freischwingmaß ist hierbei der Abstand von dem Punkt, an dem die Schutzfolie vom Substrat 4 abgelöst wird, bis zu dem Punkt, an dem die Schutzfolie 6 erstmalig die Führungswalze 9 berührt. Das Freischwingmaß wird erfindungsgemäß deshalb nicht größer als 50 mm eingestellt, weil ein größeres Freischwingmaß elektrische Entladungen zwischen abgelöster Schutzfolie 6 und Substrat 6 begünstigt, was ebenfalls zu Beschädigungen der Substratoberfläche führen kann.

Die Bewegungsbahn der ersten Schutzfolie 6 unmittelbar nach dem Abziehen vom flexiblen Substrat entspricht jedoch nicht der gemeinsamen Tangente zwischen der Führungswalze 9 und der Prozesswalze 3. Vielmehr stellt sich hierbei ein Winkel zwischen der ersten Schutzfolie 6 und der Prozesswalze 3 ein, der sich durch die auf die erste Schutzfolie 6 wirkende Bandspannung ergibt. Es ist vorteilhaft für die Qualität der nachfolgend abgeschiedenen Schicht, wenn die, auf die erste Schutzfolie 6, während des Abzugsvorgangs wirkende Bandspannung konstant gehalten wird. Bei einer Ausführungsform wird dies realisiert, indem die Führungswalze 9 als Druckmesswalze ausgebildet wird. Druckmesswalzen sind bekannt. Ist die Führungswalze 9 als Druckmesswalze ausgebildet, wird ein Istwert für den Druck ermittelt, den die über die Führungswalze 9 geführte erste Schutzfolie 6 ausübt. Der auf die Führungswalze ausgeübte Druck ist gleichzeitig eine physikalische Größe, welche die Bandspannung der ersten Schutzfolie beim Abziehen vom flexiblen Substrat 4 charakterisiert. Der ermittelte Istwert für den Druck wird mit einem Sollwert verglichen und das Drehmoment der Führungswalze 9 in Abhängigkeit vom Vergleichswert geregelt. Auf diese Weise kann der auf die Führungswalze 9 wirkende Druck, somit gleichzeitig die Bandspannung der ersten Schutzfolie 6 während des Abziehens vom flexiblen Substrat 4 und folglich auch der Winkel zwischen der ersten Schutzfolie 6 und der Prozesswalze 3 konstant gehalten werden.

Beim erfindungsgemäßen Verfahren wird die zu beschichtende Seite eines flexiblen Substrates vor, während und nach dem Beschichtungsvorgang keinem direkten mechanischen Kontakt durch Anlagenkomponenten, wie beispielsweise Umlenkrollen, ausgesetzt. Durch das erfindungsgemäße Verfahren ist daher das Risiko des Beschädigens der zu beschichtenden Oberfläche eines Substrates oder der abgeschiedenen Schicht durch direkten mechanischen Kontakt mit Anlagenkomponenten ausgeschlossen. Des Weiteren ist die Zeitspanne, innerhalb der die zu beschichtende Seite des flexiblen Substrates nicht durch eine Schutzfolie abgedeckt ist, auf den Beschichtungsvorgang selbst begrenzt und somit sehr gering. Dadurch wird auch das Risiko des Verunreinigens der zu beschichtenden Oberfläche des flexiblen Substrates und der darauf abgeschiedenen Schicht stark reduziert. Mit dem erfindungsgemäßen Verfahren ist es daher möglich, Schichten mit sehr guten und homogenen Schichteigenschaften abzuscheiden.

## Patentansprüche

1. Verfahren zum Beschichten eines flexiblen Substrates (4), welches über eine Prozesswalze (3) geführt wird, wobei das flexible Substrat (4) eine erste Schutzfolie (6) aufweist, die vom flexiblen Substrat (4) entfernt wird, bevor das flexible Substrat (4) in die Beschichtungszone einer der Prozesswalze (3) gegenüberliegenden Beschichtungseinrichtung (2) gelangt, wobei die erste Schutzfolie (6) mittels einer Führungswalze (9) vom flexiblen Substrat (4) entfernt wird und eine zweite Schutzfolie (7) auf die beschichtete Seite des flexiblen Substrates (4) aufgetragen wird, nachdem das flexible Substrat (4) die Beschichtungszone der Beschichtungseinrichtung (2) verlassen hat, **dadurch gekennzeichnet, dass**
a) die erste Schutzfolie (6) mittels der Führungswalze (9) vom flexiblen Substrat (4) entfernt wird, nachdem das flexible Substrat (4) einen mechanischen Kontakt mit der Oberfläche der Prozesswalze (3) ausgebildet hat,
b) die Führungswalze (9) mit einem Maß von 0,5 mm bis 5 mm von der Prozesswalze (3) beabstandet wird,
c) das Freischwingmaß der vom Substrat (4) abgezogenen Schutzfolie (6) zwischen der Prozesswalze (3) und der Führungswalze (9) mit einer Länge von 5mm bis 50 mm ausgebildet wird,
d) die zweite Schutzfolie (7) auf die beschichtete Seite des flexiblen Substrates (4) aufgetragen wird bevor der mechanische Kontakt zwischen Prozesswalze (3) und flexiblem Substrat (4) beendet wird.

2. Verfahren nach Anspruch 1, **dadurch gekennzeichnet, dass** die zweite Schutzfolie (7) auf die beschichtete Seite des flexiblen Substrates (4) derart aufgetragen wird, dass mit dem Verbund (8) aus beschichtetem flexiblen Substrat (4) und zweiter Schutzfolie (7) noch in einem Winkelsegment (10) der Prozesswalze (3) von mindestens 10° ein mechanischer Kontakt mit der Oberfläche der Prozesswalze (3) ausgebildet wird.

3. Verfahren nach Anspruch 1, **dadurch gekennzeichnet, dass** ein Istwert für den auf die Führungswalze (9) wirkenden Druck erfasst, mit einem Sollwert verglichen und das Drehmoment der Führungswalze (9) in Abhängigkeit vom Vergleichsergebnis geregelt wird.

4. Verfahren nach Anspruch 3, **dadurch gekennzeichnet, dass** die Führungswalze (9) als Druckmesswalze ausgebildet wird.

## Claims

1. Method for coating a flexible substrate (4) which is guided via a process roll (3), where the flexible substrate (4) has a first protective film (6), which is removed from the flexible substrate (4) before the flexible substrate (4) enters the coating zone of a coating facility (2) opposite the process roll (3), where the first protective film (6) is removed from the flexible substrate (4) by means of a guide roll (9) and a second protective film (7) is applied to the coated side of the flexible substrate (4) after the flexible substrate (4) has left the coating zone of the coating facility (2), **characterized in that**
a) the first protective film (6) is removed from the flexible substrate (4) by means of the guide roll (9) after the flexible substrate (4) has made mechanical contact with the surface of the process roll (3),
b) the guide roll (9) is at a distance with a measurement of 0.5 mm to 5 mm from the process roll (3),
c) the free-swinging distance of the protective film (6) removed from the substrate (4), between the process roll (3) and the guide roll (9), is designed with a length of 5 mm to 50 mm,
d) the second protective film (7) is applied to the coated side of the flexible substrate (4) before the mechanical contact between process roll (3) and flexible substrate (4) is ended.

2. Method according to Claim 1, **characterized in that** the second protective film (7) is applied to the coated side of the flexible substrate (4) in such a way that mechanical contact with the surface of the process roll (3) is also made in an angular segment (10) of the process roll (3) of at least 10° by the assembly (8) composed of coated flexible substrate (4) and second protective film (7).

3. Method according to Claim 1, **characterized in that** an actual value for the pressure acting on the guide roll (9) is captured and compared with a target value, and the torque of the guide roll (9) is regulated as a function of the comparison outcome.

4. Method according to Claim 3, **characterized in that** the guide roll (9) is designed as a pressure-measuring roll.

## Revendications

1. Procédé de revêtement d'un substrat flexible (4) qui est guidé sur un rouleau de traitement (3), le substrat flexible (4) comportant un premier film de protection (6) qui est retiré du substrat flexible (4) avant que le substrat flexible (4) n'atteigne la zone de revêtement d'un dispositif de revêtement (2) opposé au rouleau de traitement (3), le premier film de protection (6) étant retiré du substrat flexible (4) au moyen d'un rouleau de guidage (9) et un deuxième film de protection (7) étant appliqué sur le côté revêtu du substrat flexible (4) après que le substrat (4) a quitté la zone de revêtement du dispositif de revêtement (2), **caractérisé en ce que**
a) le premier film de protection (6) est retiré du substrat flexible (4) au moyen du rouleau de guidage (9) après que le substrat flexible (4) a établi un contact mécanique avec la surface du rouleau de traitement (3),
b) le rouleau de guidage (9) est espacé du rouleau de traitement (3) d'une distance de 0,5 mm à 5 mm,
c) le débattement libre du film de protection (6), retiré du substrat (4), entre le rouleau de traitement (3) et le rouleau de guidage (9) est conçu pour avoir une longueur de 5 mm à 50 mm,
d) le deuxième film de protection (7) est appliqué sur le côté revêtu du substrat flexible (4) avant que le contact mécanique entre le rouleau de traitement (3) et le substrat flexible (4) ne soit terminé.

2. Procédé selon la revendication 1, **caractérisé en ce que** le deuxième film de protection (7) est appliqué sur le côté revêtu du substrat flexible (4) de telle sorte que le composite (8) formé du substrat flexible revêtu (4) et du deuxième film de protection (7) permet d'établir encore un contact mécanique avec la surface du rouleau de traitement (3) dans un segment angulaire (10) du rouleau de traitement (3) d'au moins 10°.

3. Procédé selon la revendication 1, **caractérisé en ce qu'**une valeur réelle de la pression agissant sur le rouleau de guidage (9) est acquise et comparée à une valeur de consigne, et le couple du rouleau de guidage (9) est régulé en fonction du résultat de la comparaison.

4. Procédé selon la revendication 3, **caractérisé en ce que** le rouleau de guidage (9) est conçu comme un rouleau de mesure de pression.
